Europäisches Patentamt

(19) European Patent Office

Office européen des brevets

(11) Publication number: **0 233 018 B1**

## (12) EUROPEAN PATENT SPECIFICATION

(45) Date of publication of patent specification: 07.08.91    (51) Int. Cl.⁵: **B23K 1/00, B23K 3/04**

(21) Application number: 87300791.8

(22) Date of filing: 29.01.87

(54) Soldering device.

(30) Priority: 01.02.86 GB 8602504
15.07.86 GB 8617240

(43) Date of publication of application:
19.08.87 Bulletin 87/34

(45) Publication of the grant of the patent:
07.08.91 Bulletin 91/32

(84) Designated Contracting States:
AT BE CH DE ES FR GR IT LI LU NL SE

(56) References cited:
EP-A- 0 097 796
US-A- 4 295 596
US-A- 4 426 571
US-A- 4 552 300
US-A- 4 605 152

(73) Proprietor: THE GENERAL ELECTRIC COM-
PANY, p.l.c.
1 Stanhope Gate
London W1A 1EH(GB)

(72) Inventor: Todd, Richard Ian
40 Petunia Crescent Springfield
Chelmsford Essex CM1 5YP(GB)
Inventor: Claydon, Robert Charles
19 St Giles Crescent
Maldon Essex CU9 6 HS(GB)

(74) Representative: Hyden, Martin Douglas et al
GEC Patent Department GEC-Marconi Re-
search Centre West Hanningfield Road
Great Baddow Essex CM2 8HN(GB)

Rank Xerox (UK) Business Services

## Description

This invention relates to a soldering device which is suitable for the removal and replacement of components which are secured to a substrate by means of solder.

Solder is currently the most commonly used way of mounting electrical components on an electrical circuit, but it can be difficult and tedious to remove a defective component and to replace it.

It has been proposed to utilize a suction device operating under a partial vacuum to engage with a component so that when the solder is melted by means of hot gas or the like withdrawal of the suction device is accompanied by removal of the component. Customarily the withdrawal of the suction device is achieved manually or by means of a spring. Both techniques have their drawbacks as the manual method requires the intervention of an operator and the other method requires the careful adjustment (usually manually) of the spring tension. Also, these known techniques require that the aperture for directing hot gas onto the solder joints fit precisely on to the component to be removed, so that different apertures need to be fitted to the hot gas device for each type of component and, in operation, the hot gas device must be very accurately positioned with respect to the component to be removed.

US-A-4552300 describes a suction device in which a suction member is held above a component and suction is initially applied at a low level to withdraw the hot gas used to melt the solder after which the suction is increased and the component drawn onto the member so as to break the surface tension of the solder. The member with the attached component is then withdrawn from the substrate by the action of springs.

US-A-4605152 describes a device in which a suction tube is forced against a compression spring, onto the component and is then released. The suction holds the component onto the tube and the spring effects withdrawal from the substrate.

According to the present invention, there is provided a device for removing a component from a substrate to which it is secured by solder including a moveable nozzle to which suction can be applied and which can be positioned against the component; an assembly including, in operation, an enclosure surrounding the nozzle and arranged, in operation, to direct hot gas onto the solder to soften it, characterised in that the nozzle is moveably mounted by means of a piston and cylinder arrangement, a bellows arrangement or a flexible diaphragm arrangement such that the effect of suction on the arrangement causes the nozzle to exert a lifting force on the component, and to retract the nozzle relative to the substrate, thereby lifting the component from the substrate, when the solder is molten.

This gives the advantage that because the same suction that attaches the component to the moveable member exerts the lifting force on the component no separate means of withdrawal of the suction device is needed.

By providing an enclosure which surrounds the moveable member and the component and into which hot gas is directed, the amount of hot gas which is needed is reduced and confines the heat to the region which it is required and reduces the heating of any neighbouring components.

The means by which the suction caused the moveable member to pull the component is preferably a piston-and-cylinder arrangement with the piston preferably being fixed and the cylinder being defined by the moveable member. In such an arrangement it maybe convenient for the suction to be applied through the "piston" though it could alternatively be applied through a wall of the cylinder. Where the suction is applied through the "piston" the latter can in fact be constituted by a pipe on which the cylinder slides and through which the vacuum is applied.

Preferably the enclosure comprises a separable skirt portion which in operation encircles the component to be removed from the substrate. This is advantageous because the size of the enclosure is determined by this skirt portion, so if the size of the enclosure needs to be changed, only the skirt need be altered.

In one preferred arrangement the hot gas flows to the enclosure through a first passage which surrounds another passage through which the vacuum is applied. This first passage may be secured to a platten which co-operates with but is not secured to a skirt to define the aforementioned enclosure.

This allows a series of different skirts to be used in quick succession by simply placing the platen to cooperate with each skirt in turn. The different skirts may be needed to suit components of different shapes and sizes and to fit between given components and neighbouring components.

Advantageously a baffle is mounted within the enclosure to prevent hot gas passing directly onto the component. This can reduce the thermal stresses inflicted on the component. Preferably the baffle is mounted on said moveable member giving the advantage that the position of the baffle relative to the component, and thus the extent to which the baffle stops hot gas being directed onto the component, remains constant throughout the removal process.

A visual indicator may be provided to show when the component is lifted clear of the substrate.

This is advantageous because it allows the operator to stop the supply of hot gas to the enclosure at once when the component lifts, thus minimising thermal damage to the component and substrate.

It will be appreciated that, if sufficient vacuum is applied before the solder melts, the action of the vacuum itself can cause the moveable member to retract and to lift the component from the substrate. This is advantageous because it removes the need for the time required to melt the solder to be calculated in advance. Advantageously means are provided to hold the moveable member clear of the component so that the device can be used, with the suction not applied, as a hot air source for soldering components to the substrate.

It is desirable to combine in a single step the removal of the component from the substrate with the release of the solder by means of which the component is secured to the substrate. The invention is particularly suitable for the removal of so called surface mounted components from printed circuit boards. The term printed circuit board is used herein in a general sense to encompass any electrically insulating substrate which carries localised electrically conductive regions on a major surface thereof. Components are attached to a printed circuit board either by elongate legs which pass through apertures in the board and are secured by means of solder to conductive regions on the reverse face of the board or by conductive pads or leads which are soldered to conductive regions located on the same side of the board as, and adjacent to, the component. The latter method is termed surface mounting, and it is for components so mounted that the invention is most usefully applicable.

The degree of suction required will of course depend on the weight of the component, the nozzle diameter and the quality of the seal between the nozzle and the component. In practice, the electrical components are small and light, and so a small vacuum pump will typically be quite sufficient. Once a component has been removed from the printed circuit board, a replacement component can be positioned in its place, and secured to the electrically conductive region by using the hot air directed to melt solder around the conductive pads or leads of the component.

The invention is further described, by way of example, with reference to the following drawings, in which:

Figure I shows a cut away view, and sectional elevation through line X-X of the cut away view of an embodiment of the device,

Figures 2 and 3 show stages in the removal of a component from a printed circuit board using this embodiment,

Figure 4 shows the replacement of a component using this embodiment,

Figure 5 shows a cut away view of an alternative embodiment of the invention, and

Figure 6 shows a further view of this alternative embodiment of the invention.

Figure 7 shows this alternative embodiment of the invention in use. Similar parts have the same reference numerals throughout.

A device for removing a component from a printed circuit board is shown in Figure I. A component I to be unsoldered is shown mounted on a printed circuit board 2. The printed circuit board carries localised conductive regions 3 to which leads 4 forming part of the component I are secured by means of solder 5. Although the illustrated component I has projecting leads, it may instead be provided with integral conductive pads. The fixed tube 6 is open-ended and is made of stainless steel with an internal diameter of 2.3mm and an external diameter of 3.0mm. The device is provided with an enclosure 7 which surrounds two concentric tubes 6 and 8. Tube 8 is slidably mounted around tube 6 which is connected to a vacuum pump (not shown) by means of a further tube 9. Tube 9 is rigidly fixed where it travels through the wall of a hot gas duct I0. Tube 6 is co-axial with hot gas duct I0. The sliding tube 8 is made from stainless steel with an internal diameter of 3.2mm. Tube 8 has an open lower end and a semi-circular section cut from its upper end in order to allow it to slide over fixed tube 6 despite the fixed tube 9 projecting at right angles. The extreme upper part of tube 8 is bent over such that the bent over part and the bottom of the semi-circular cut away section define the lower and upper limits of the movement of sliding tube 8 respectively.

The sliding surfaces of tubes 6 and 8 are smooth enough to allow sliding tube 8 to slide over fixed tube 6 under its own weight while forming an adequate vacuum seal.

The hot gas duct I0 carries hot gas, preferentially hot Nitrogen, from a heating unit II which includes a heating element I6 over which the gas is constrained to flow around the concentric tubes 6 and 8 and down into the enclosure 7. Hot gas duct I0 is made of stainless steel with an internal diameter of 7.0mm to allow enough room for the gas to pass. The enclosure 7 is made from stainless steel with internal dimensions 22mm x 22mm x 7mm and is attached to the end of the hot gas duct 10 and confines the hot gas around the component 1. A baffle plate 12 is fixed to the end of the sliding tube 8 in order to reduce the thermal shock to the component 1 to be removed. Baffle plate 12 is made from a thin sheet of stainless steel and is slightly larger than the bore of the hot gas duct 10. One side of baffle plate 12 extends outwards to form a tongue 13 to which a vertical threaded rod 14 of stainless steel is connected. This threaded rod 14 protrudes through a hole in enclosure 7 and is fitted with an internally threaded brass nut 15. When the nut 15 is at the upper end of rod 14 it does not restrict the movement of the sliding tube 8, but when the nut 15 is at the lower end of rod 14 it holds sliding tube 8 in its highest possible position.

Obviously the device could be made from a wide range of materials, provided said materials can withstand the temperature of the hot gas and the invention could be embodied in other ways, for example, having the sliding tube inside the fixed tube, or using a bellows instead of sliding concentric tubes, or not having the baffle plate 12 and associated parts.

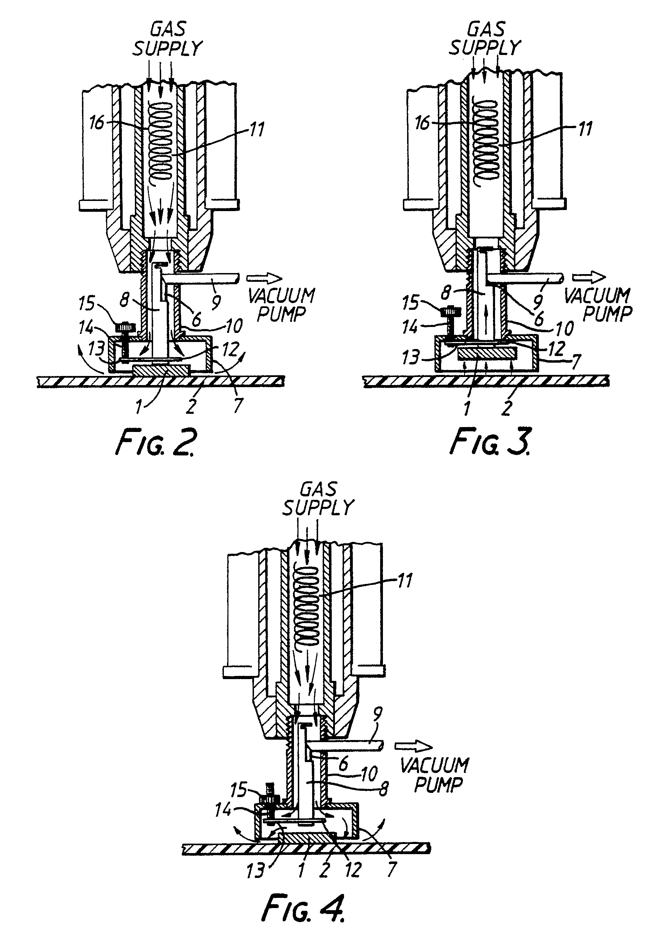

Operation of the invention will now be described with reference to Figures 2 to 4. With reference to Figure 2, to unsolder and remove the component, the nut 15 is left in its normal position at the top of the threaded rod 14 and the device is placed so that the component 1 to be removed is inside and approximately in the centre of the enclosure 7. The enclosure 7 does not seal with the printed circuit board 2 because a gap must be left to allow circulation of the hot gas past the component 1. The sliding tube 8 drops down under its own weight so that its lower end rests on the top of the component 1. The hot gas supply and vacuum pump are then switched on, and the period for which hot gas is supplied, approximately 20 seconds, is controlled by a timer to prevent overheating the component and to ensure duplicability of the procedure. When the solder 5 melts, the component 1 is automatically lifted clear of the printed circuit board 2 as shown in Figure 3, by virtue of the suction effect exerted by the vacuum pump; the operator knows when this occurs because nut 15 and threaded rod 14 will rise with the sliding tube 8, providing a visual indication. In practice, if sealing in the system is inadequate, it may be found necessary to switch on the vacuum pump whilst the solder is still molten, but after the timed "pulse" of hot gas has finished in order to prevent loss of hot gas into the vacuum system. In practice, when a number of surface mounted components with varying size and outline are closely spaced on a substrate, it can be useful for the enclosure 7 to be removeable from the device, so that alternative configurations or sizes of enclosure can be used.

Replacement of an electronic component is shown in Figure 4. The component 1 is placed at the correct point on the printed circuit board 2 so that the conductive pads 4 align with the conductive regions 3. Solder is applied to either the component 1 or the printed circuit board 2 or both, usually prior to component placement. The nut 15 is

tightened up on the threaded rod 14 and so holds the sliding tube 8 clear of the component 1. The device is placed so that the component to be soldered is inside and approximately in the centre of the enclosure 7. The hot gas supply only is then switched on and is allowed to heat the component until the solder 5 at the joints between component 1 and the printed circuit board 2 melts, forming the required joints.

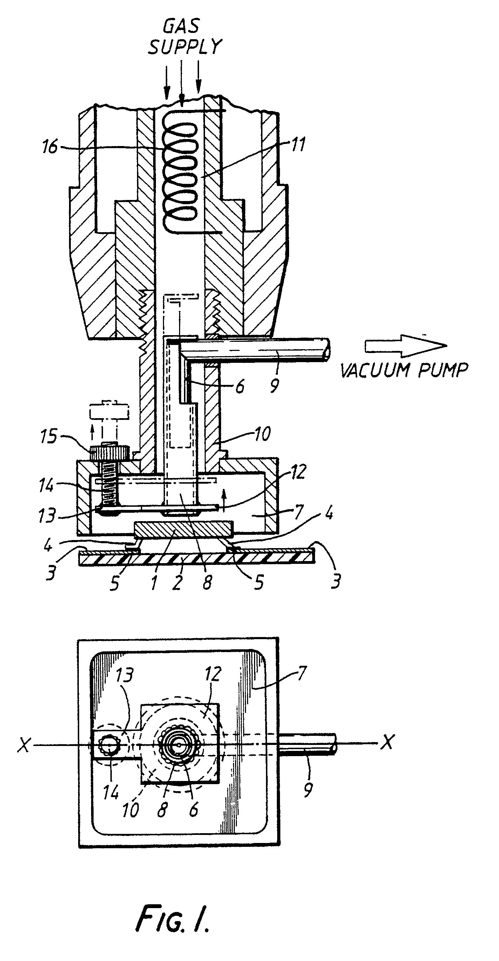

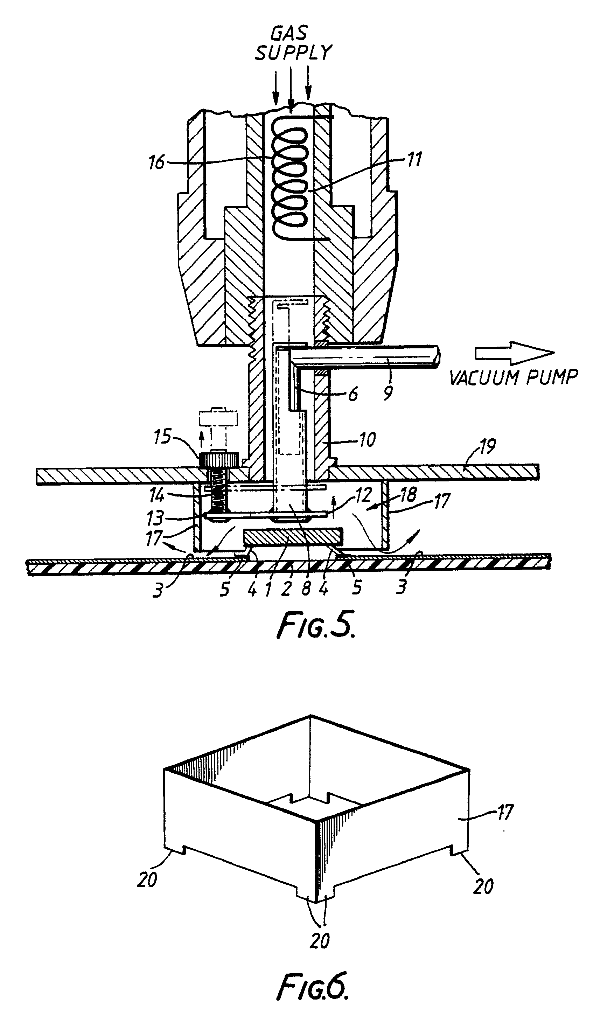

A device having an alternative form of enclosure is shown for removing a component from a printed circuit board in Figure 5. Where appropriate the same reference numerals are used as in Figure 1. The component 1 to be unsoldered is shown mounted on the printed circuit board, as before.

The hot gas duct 10 carries the hot gas from the heating unit 11 which includes a heating element 16 over which the gas is constrained to flow around the concentric tubes 6 and 8 and down into the enclosure 18 which in this embodiment is formed by open ended skirt 17 and platen 19. Platen 19 is attached to the end of hot gas duct 10 so that it has a fixed position with respect to the tubes 6 and 9 and is a flat square stainless steel plate having an area greater than any component it will be required to unsolder or resolder. The skirt 17, as shown in figure 6, is formed with a rectangular shape and size such that it completely encircles a component leaving enough room for hot gas from duct 10 to flow around the component. The contact between platen 19 and skirt 17 is not completely gas tight but the seal is good enough to ensure that most gas from gas duct 10 flows over the component 1 and out under the raised edges of the skirt 17 through spaces formed by lugs 20.

Although the rectangular skirt can fit around a range of sizes of components it will generally be convenient, especially in circuit boards with dense component packing, to have a number of different sized and shaped skirts so as to provide a close fit for each size of component.

In practice, if a number of components are to be removed from the same printed circuit board, a separate skirt 17 is placed around each component, and the platen 19 placed on the upper rim of each skirt in turn whilst that component is removed. In this way a large number of components can be easily and quickly removed without damaging adjacent components.

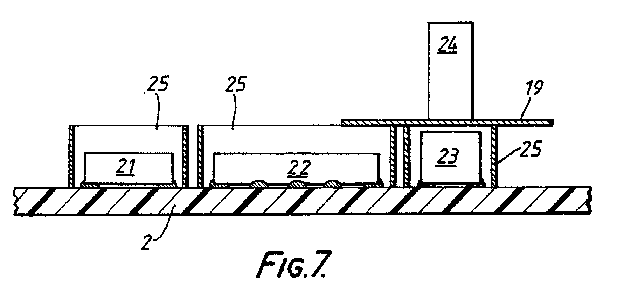

Such an arrangement is illustrated in Figure 7, in which the printed circuit board 2 carries three components 21, 22, 23. All three components are to be removed in turn by the device shown diagramatically at 24, and each component is provided with its own skirt 25 which completely encircles it. The platen 19 of the device 24 is brought into contact with the upper rim of each skirt in turn, and the component removed in accordance with the previously described mode of operation.

## Claims

1. A device for removing a component (1) from a substrate (2) to which it is secured by solder (5) including a movable nozzle (8) to which suction can be applied and which can be positioned against the component (1); an assembly (10, 11, 16) including, in operation, an enclosure (7, 18) surrounding the nozzle (8) and arranged, in operation, to direct hot gas onto the solder (5) to soften it, characterised in that the nozzle (8) is movably mounted by means of a piston and cylinder arrangement, a bellows arrangement or a flexible diaphragm arrangement such that the effect of suction on the arrangement causes the nozzle (8) to exert a lifting force on the component (1), and to retract the nozzle relative to the substrate (2), thereby lifting the component (1) from the substrate (2), when the solder (5) is molten.

2. A device as claimed in claim 1 in which the enclosure (7) is attached to the assembly (10, 11, 16).

3. A device as claimed in claim 1 and wherein the enclosure (18) includes a separable skirt portion (17, 25) which in operation encircles the component (1) which is to be removed from the substrate (2).

4. A device as claimed in claim 3 and wherein the enclosure (18) includes a flat platen (19) adapted to co-operate with an upper rim of the skirt (17, 25).

5. A device as claimed in claim 1 and wherein the nozzle (8) forms part of one tube which is slidable relative to another tube (6), and mounted such that when suction is applied to the nozzle (8) via said other tube (6) and the free end of the nozzle (8), is obscured by the component (1), the component (1) and said one tube are urged towards the other tube (6).

6. A device as claimed in claims 4 and 5 and wherein the platen (19) is mounted in a fixed position with respect to said other tube (6).

7. A device as claimed in claim 1, or 3 and wherein the enclosure (7, 18) is dimensioned so as to surround the component (1).

8. A device as claimed in any preceding claim and wherein a baffle (12) is mounted within said enclosure (7, 18) to prevent hot gas from being directed directly onto a component (1).

9. A device as claimed in claim 8 and wherein the baffle (12) is mounted on said one tube (8).

10. A device as claimed in any of claims 3 to 7 wherein means (13, 14, 15) are provided to hold said one sliding tube (8) clear of the component (1).

11. A device as claimed in any of claims 5 to 9 and wherein said further tube (6) is fixed relative to the enclosure (7, 18) and said one sliding tube (8) slides with respect to the enclosure (7, 18).

12. A device as claimed in any preceding claim and wherein a visual indicator (15) is provided to show when said component (1) is lifted clear of said substrate (2).

## Revendications

1. Appareil d'extraction d'un composant (1) d'un substrat (2) auquel il est fixé par de la soudure (5), comprenant une buse mobile (8) à laquelle une aspiration peut être transmise et qui peut être positionnée contre le composant (1), un ensemble (10, 11, 16) comprenant, pendant le fonctionnement, une enceinte (7, 18) qui entoure la buse (8) et qui, pendant le fonctionnement, est disposée afin qu'elle projette des gaz chauds sur la soudure (5) afin que celle-ci se ramollisse, caractérisé en ce que la buse (8) est montée afin qu'elle soit mobile, à l'aide d'un vérin, d'un ensemble à soufflet ou d'un ensemble à diaphragme flexible, si bien que l'effet de l'aspiration sur l'ensemble provoque l'application par la buse (8) d'une force de soulèvement au composant (1) et le recul de la buse par rapport au substrat (2), si bien que le composant (1) est écarté du substrat (2) lorsque la soudure (5) est fondue.

2. Appareil selon la revendication 1, dans lequel l'enceinte (7) est fixée à l'ensemble (10, 11, 16).

3. Dispositif selon la revendication 1, dans lequel l'enceinte (18) comporte une partie séparable de jupe (17, 25) qui, pendant le fonctionnement, entoure le composant (1) qui doit être retiré du substrat (2).

4. Appareil selon la revendication 3, dans lequel l'enceinte (18) comporte un plateau plat (19) destiné à coopérer avec un rebord supérieur de la jupe (17, 25).

5. Appareil selon la revendication 1, dans lequel la buse (8) fait partie d'un tube qui peut coulisser par rapport à un autre tube (6) et qui est montée afin que, lorsque l'aspiration est appliquée à la buse (8) par l'autre tube (6) et l'extrémité libre de la buse (8) est bouchée par le composant (1), le composant (1) et le premier tube sont repoussés vers l'autre tube (6).

6. Appareil selon les revendications 4 et 5, dans lequel le plateau (19) est monté en position fixe par rapport à l'autre tube (6).

7. Appareil selon la revendication 1 ou 3, dans lequel l'enceinte (7, 18) a des dimensions telles qu'elle entoure le composant (1).

8. Appareil selon l'une quelconque des revendications précédentes, dans lequel un déflecteur (12) est monté dans l'enceinte (7, 18) afin qu'il empêche la projection directe des gaz chauds sur un composant (1).

9. Appareil selon la revendication 8, dans lequel le déflecteur (12) est monté sur le premier tube (8).

10. Appareil selon l'une quelconque des revendications 3 à 7, dans lequel un dispositif (13, 14, 15) est destiné à maintenir le premier tube coulissant (8) à distance du composant (1).

11. Appareil selon l'une quelconque des revendications 5 à 9, dans lequel le tube supplémentaire (6) est fixé par rapport à l'enceinte (7, 18) et le premier tube coulissant (8) coulisse par rapport à l'enceinte (7, 18).

12. Appareil selon l'une quelconque des revendications précédentes, dans lequel un indicateur visuel (15) est disposé afin qu'il indique le moment où le composant (1) s'est soulevé à distance du substrat (2).

**Patentansprüche**

1. Gerät zum Entfernen einer Komponente (1) von einem Substrat (2), an der sie durch Lot (5) befestigt ist, mit einer bewegbaren Düse (8), durch die Saugwirkung angelegt und die gegen die Komponente (1) angesetzt werden kann; einer Anordnung (10,11,16), welche im Betrieb eine die Düse (8) umgebende Umhüllung (7,18) enthält und im Betrieb angeordnet ist, heißes Gas auf das Lot (5) zu richten, um es zu erweichen, dadurch gekennzeichnet, daß die Düse (8) mittels einer Kolben/Zylinder-Anordnung, einer Balganordnung oder einer flexiblen Membrananordnung bewegbar angebracht ist, so daß die Auswirkung der Saugkraft auf die Anordnung die Düse (8) eine Anhebekraft auf die Komponente (1) ausüben und die Düse relativ zum Substrat (2) zurückziehen läßt, wodurch die Komponente (1) vom Substrat (2) abgehoben wird, wenn das Lot (5) geschmolzen ist.

2. Gerät nach Anspruch 1, bei dem die Umhüllung (7) an der Anordnung (10,11,16) angeordnet ist.

3. Gerät nach Anspruch 1 und bei dem die Umhüllung (18) einen abnehmbaren Schurzabschnitt (17,25) enthält, der im Betrieb die von dem Substrat (2) zu entfernende Komponente (1) umgibt.

4. Gerät nach Anspruch 3 und bei dem die Umhüllung (18) eine ebene zum Zusammenwirken mit dem oberen Rand des Schurzes (17,25) ausgelegte Platte (19) enthält.

5. Gerät nach Anspruch 1, und bei dem die Düse (8) einen Teil eines Rohrs bildet, das relativ zu einem anderen Rohr (6) gleitbar und so angebracht ist, daß, wenn Saugwirkung für die Düse (8) über das andere Rohr (6) aufgebracht wird und das freie Ende der Düse (8) durch die Komponente (1) verdeckt ist, die Komponente (1) und das eine Rohr zu dem anderen Rohr (6) hin gedrängt werden.

6. Gerät nach Anspruch 4 und 5 und bei dem die Platte (19) in einer festen Lage bezüglich des anderen Rohrs (6) angebracht ist.

7. Gerät nach Anspruch 1 oder 3 und bei dem die Umhüllung (7,18) so dimensioniert ist, daß sie die Komponente (1) umgibt.

8. Gerät nach einem der vorangehenden Ansprüche und bei dem eine Prallplatte (12) innerhalb der Umhüllung (7,18) angebracht ist, um zu verhindern, daß heißes Gas direkt auf eine Komponente (1) gerichtet wird.

9. Gerät nach Anspruch 8, und bei dem die Prallplatte (12) an dem einen Rohr (8) angebracht ist.

10. Gerät nach einem der Ansprüche 3 bis 7, bei dem Mittel (13,14,15) vorgesehen sind, um das eine Gleitrohr (8) von der Komponente (1) frei zu halten.

11. Gerät nach einem der Ansprüche 5 bis 9 und bei dem das weitere Rohr (6) relativ zu der Umhüllung (7, 18) fest angebracht ist und das eine Gleitrohr (8) bezüglich der Umhüllung (7,18) gleitet.

12. Gerät nach einem der vorangehenden Ansprüche und bei dem eine Sichtanzeige (15) vorgesehen ist, um anzuzeigen, wenn die Komponente (1) von dem Substrat (2) freigehoben ist.

GAS
SUPPLY

VACUUM PUMP

16

11

15

14

13

6

9

10

12

7

4

4

4

3

5

1

2

8

5

3

13

12

7

X

X

14

10

8

6

9

FIG. I.

GAS
SUPPLY

16

11

15
8
14
6
10
13
12
VACUUM
PUMP
9
1 2 7

FIG. 2.

GAS
SUPPLY

16

11

15
8
14
9
6
10
13
12
7
VACUUM
PUMP
1 2

FIG. 3.

GAS
SUPPLY

11

9
6
10
VACUUM
PUMP
8
15
14
13 1 2 12 7

FIG. 4.

GAS
SUPPLY

16

11

VACUUM PUMP

6
9

15

10

19

14

12
18
17

13

17

3

5 4 1 2 8 4 5 3

FIG.5.

17

20

20

20

FIG.6.

FIG.7.